# EUROPÄISCHE PATENTANMELDUNG

(11) **EP 4 114 164 A1**
(43) Veröffentlichungstag der Anmeldung: **04.01.2023**
(21) Anmeldenummer: 21182450.3
(22) Anmeldetag: 29.06.2021
(51) Int. Cl.: H05K 13/08

(54) **ERMITTELN EINES QUALITÄTSWERTES BEIM BESTÜCKEN EINES ELEKTRISCHEN BAUELEMENTS**

(71) Anmelder: Siemens Aktiengesellschaft, 80333 München (DE)
(72) Erfinder: Blank, Rene, 12249 Berlin (DE); Borwieck, Carsten, 14052 Berlin (DE); Franke, Martin, 14089 Berlin (DE); Frühauf, Peter, 14612 Falkensee (DE); Heimann, Matthias, 14469 Potsdam (DE); Knofe, Rüdiger, 14513 Teltow (DE); Müller, Bernd, 16259 Falkenberg (DE); Nerreter, Stefan, 15754 Heidesee OT Blossin (DE); Wittreich, Ulrich, 16727 Velten (DE)

(57) **Zusammenfassung**

Die Erfindung betrifft ein Verfahren zum Ermitteln eines Qualitätswertes (Q) beim Bestücken eines elektrischen Bauelements (20) auf eine Oberfläche (30). Um Prozessabweichungen in der Elektronikfertigung frühzeitig zu erkennen und den Fertigungsprozess zu verbessern werden die folgenden Schritte vorgeschlagen:
- Erfassen ein oder mehrerer Prozessgrößen (F, VAC, POS) beim Bestücken des Bauelements (20),
- Ermitteln des Qualitätswertes (Q) durch ein Modell (40), das auf Basis von Erfahrungswerten (F*, VAC*, POS*) für die Prozessgrößen (P, VAC, POS) den Qualitätswert (Q) ausgibt.

Die Erfindung betrifft weiterhin ein Verfahren zum Bestücken von Bauelementen (20), eine Überwachungseinrichtung (130) und einen Bestückautomat (100).

## Beschreibung

Die Erfindung betrifft ein Verfahren zum Ermitteln eines Qualitätswertes beim Bestücken eines elektrischen Bauelements. Ein derartiges Verfahren kommt beispielsweise in der Elektronikfertigung zum Einsatz. Die Erfindung betrifft weiterhin ein Verfahren zum Bestücken von Bauelementen, eine Überwachungseinrichtung und einen Bestückautomat.

Bestückautomaten sind dazu ausgebildet elektrische Bauelemente automatisiert zu bestücken. Das Verfahren ist dabei für alle Formen von automatisiert bestückbaren Bauelementen anwendbar, insbesondere für oberflächenmontierte Bauelemente (auch surface mounted device - SMD) aber auch für THT-Bauelemente. Für eine einzige Schaltung werden teilweise mehrere hundert Bauteile bestückt was die Überwachung der Qualität des Bestückergebnisses für jedes einzelne der Bauteile schwierig macht.

In der Elektronikmontage werden in einem schnellen, hochautomatisierten Prozess Bauelemente auf/in Leiterplatten bestückt. Hierbei fallen viele Prozessdaten / Prozessgrößen z.B. Positionen X/Y/Z, Kraftverläufe, Vakuumverläufe und Informationen aus der optischen Bauteilvermessung an. Die Bauteile sind sehr filigran (kleine Anschlüsse mit geringen Abständen) und dementsprechend empfindlich. Es werden noch viele THT Bauelemente (auch für den THR Prozess) bestückt, bei denen die Toleranzkette (LP/BE) einen großen Einfluss auf das Bestückergebnis und das Lötergebnis in Folgeprozessen hat. Aktuell werden auftretende Fehler nur teilweise erkannt und diese führen zu hohen Nacharbeitskosten. Die einzelnen Bestückmodule der Bestückautomaten verfügen jeweils über mehrere identische/ähnliche Portale bzw. Bestückköpfe und weitere Funktionselemente (Tisch, Klemmung ...), deren Zustand sich über die Laufzeit unterschiedlich verändert.

Bisher gibt es nur die Möglichkeit der Nutzung eines dedizierten AOIs oder eine manuelle Inspektion vor den Folgeprozessen. Selbst bei einer modernen AOI ist die Erkennungsquote von Fehlern nicht optimal, da viele Anschlüsse der Bauelemente nicht einfach einsehbar sind, weil diese z. B. verdeckt sind.

Der Erfindung liegt die Aufgabe zugrunde, Prozessabweichungen in der Elektronikfertigung frühzeitig zu erkennen und den Fertigungsprozess zu verbessern.

Die Aufgabe wird durch ein Verfahren mit den im Anspruch 1 angegebenen Merkmalen gelöst.

Das Verfahren zum Ermitteln eines Qualitätswertes beim Bestücken eines elektrischen Bauelements auf eine Oberfläche, z. B. auf eine gedruckte Leiterplatte (PCB) oder ein Keramik-Kupfer-Substrat (direct bonded copper, DBC / DCB), weist dabei die folgenden Schritte auf:
- Erfassen ein oder mehrerer Prozessgrößen beim Bestücken des Bauelements,
- Ermitteln des Qualitätswertes durch ein Modell, das auf Basis von Erfahrungswerten für die Prozessgrößen den Qualitätswert ausgibt.

Das Verfahren ist computerimplementiert und kann dabei auf einer Steuerung eines Bestückautomaten oder einer übergeordneten Steuerung ausgeführt werden.

Erfahrungswerte sind dabei Sollwerte für die Prozessgrößen, die entweder aus Simulationen des Bestückprozess erwartet werden oder aus tatsächlichen Aufnahmen von Prozessgrößen erstellt wurden. Solche Aufnahmen können beispielsweise beim Bestücken von als fehlerfrei bewerteten Baugruppen erzeugt werden. Dazu können über einen Zeitraum für mehrere Bestückvorgänge Prozessgrößen aufgezeichnet werden, die bestückten Baugruppen einer Befundung unterzogenen werden, um die Bestückvorgänge zu bewerten und wenn diese den Qualitätskriterien entsprechen als Erfahrungswert abgespeichert werden. Die Erfahrungswerte können dabei für verschiedene Größen von elektrischen Bauteilen zur Verfügung gestellt werden. Es können also, auf Basis von SMD Package-Types, oder Gruppen von ähnlichen Package Types, Erfahrungswerte zur Verfügung gestellt werden. Simulative sowie aufgenommene Erfahrungswerte können problemlos kombiniert werden, sodass eine Datenbank von Erfahrungswerten für Bauteile entsteht.

Der Qualitätswert ist ein Maß für die Qualität der Bestückung des Bauelements. Als Qualitätswert kann beispielsweise ein prozentualer Wert angegeben werden, der die Erfüllung oder die Vollständigkeit der Bestückung angibt. In einem Beispiel könnte 0% ausgegeben werden, wenn keine Bestückung erfolgt ist oder diese so schlecht ist, dass kein elektrischer Kontakt zustande kommt. 100% könnte dementsprechend für eine Bestückung des Bauelements exakt nach Spezifikation und mit engen Toleranzen vergeben werden. Es ist denkbar, dass der Qualitätswert die Bestückung lediglich in Kategorien unterteilt, z.B. "ohne Befund - 0" für eine Bestückung im Soll; "Inspektion notwendig - 1" für eine Nachinspektion der Baugruppe und "Fehler - 2" für eine Bestückung die fehlerhaft war.

Das Erfassen der Prozessgrößen kann dabei kontinuierlich als ein Verlauf der Prozessgrößen oder zu festgelegten Zeit- oder Prozesspunkten geschehen; z.B. nach dem Anlegen des Unterdrucks, am Scheitelpunkt des Positionierens und am Endverbleib des Bauelements z. B. einmal knapp über der Position und einmal, wenn der Vorgang beendet wurde, der Manipulator das Bauelement aber noch nicht freigegeben hat.

Das Ermitteln des Qualitätswertes durch das Modell wird auf Basis der Erfahrungswerte durchgeführt. Das Modell kann eine Datenbank von Erfahrungswerten aufweisen oder darauf zugreifen und jeweils für den aktuellen Bestückprozess des jeweiligen Bauelements einen Erfahrungswert als Sollwert zum Vergleich heranziehen. Weisen die Prozessgrößen Abweichungen ab, so schlagen diese sich in einem dementsprechend angepassten Qualitätswert nieder was wiederum zu einem Aussortieren oder einer Nachkontrolle der Baugruppe führt.

In einer weiteren Ausführungsform wird beim Erfassen zumindest eine Prozessgröße für die folgenden Schritte erfasst:
- Aufnehmen des Bauelements,
- Positionieren des Bauelements und/oder
- Absetzen des Bauelements auf der Oberfläche.

Es können Prozessgrößen für jeden der Schritte erfasst werden. Um nicht unnötig viele Daten anzusammeln ist denkbar, dass nur in den kritischen Phasen Prozessgrößen erfasst werden, also beispielsweise direkt beim Aufnehmen und beim Absetzen des Bauelements. Wird ein magazingestütztes Bauelement Bereitstellungssystem verwendet so kann das Aufnehmen als einfüttern des Bauelements durch das Magazin ausgestaltet sein.

In einer weiteren Ausführungsform ist das Modell zum Bestimmen des Qualitätswertes auf Basis einer Abweichung von den Erfahrungswerten ausgebildet. Im einfachsten Fall kann ein einzelner Sollwert mit einem einzelnen Istwert zum Beispiel eine Maximalkraft beim Bestücken verglichen werden und so einen Qualitätswert bestimmt werden. Es ist aber ebenso denkbar, dass Verläufe von Erfahrungswerten mit Verläufen der Prozessgröße verglichen werden.

In einer weiteren Ausführungsform wird als Prozessgröße zumindest eine Unterdruckgröße und/oder ein Kraftgröße für das Bauelement erfasst. Regelmäßig kommen in Bestückautomaten Unterdruckpipetten oder Vakuumpipetten zum Einsatz. Das angelegte Vakuum bzw. der angelegte Unterdruck lässt sich dabei als Prozessgröße verwenden. Werden mechanische und nicht auf unterdruckbasierte Manipulatoren verwendet so können Drehmoment und Kraftgrößen ebenso verwendet werden; z.B. durch Auswertung der Ströme. Als Kraftgröße ist auch die Kraft, die der Manipulator aufwendet, um das Bauelement auf die Position zu drücken als Prozessgröße verwendbar.

In einer weiteren Ausführungsform wird als Prozessgröße zumindest eine Position, eine Geschwindigkeit und/oder eine Beschleunigung des Manipulators und/oder des Bauelements erfasst. Kommt es zur Abweichung von einer soll Position oder von Erfahrungswerten der Geschwindigkeit und oder Beschleunigung so kann dies auch auf einen mangelhaften Qualitätswert hindeuten.

In einer weiteren Ausführungsform werden die Prozessgrößen als Zeitverlauf eines Bestückvorgangs des Bauelements erfasst. Alternativ können die Prozessgrößen auch als Zustandsverlauf erfasst werden, also als Verlauf der Größen in bestimmten Zuständen. Es ist vorteilhaft, wenn einzelne Abschnitte in den Prozessgrößen identifizierbar sind und den jeweiligen Zuständen also z. B. dem Aufnehmen dem Positionieren oder dem Absetzen zugeordnet sind.

In einer weiteren Ausführungsform umfasst das Modell ein mit den Erfahrungswerten trainiertes Modell des maschinellen Lernens.

Insbesondere Modelle des überwachten maschinellen Lernens (engl: supervised learning models) sind hier gut geeignet, da die Prozessgrößen als Eingangsgrößen zum großen Teil gut erfassbar oder approximierbar sind und der Qualitätswert als Ausgangsgröße einen trainierbaren Zusammenhang dazu aufweist.

Als besonders vorteilhafte Ausgestaltungen der Modelle des überwachten maschinellen Lernens haben sich im vorliegenden Fall neuronale Netze, Support Vektor Maschinen, sowie Random Forest Modelle (allg.: Entscheidungsbäume) herausgestellt.

Zum Trainieren der Modelle des maschinellen Lernens können Erfahrungswerte als Trainingsdaten zur Verfügung gestellt werden. Vorzugsweise werden Trainingsdaten verwendet, die auf Erfahrungswerten mit den dazugehörigen Qualitätseinschätzungen (also gelabelte Trainingsdaten) basieren. Zum Training können sowohl Erfahrungswerte verwendet werden, bei denen der Bestückvorgang erfolgreich und den Qualitätskriterien entsprechend ausgeführt wurde als auch Erfahrungswerte die unzureichende Bestimmungsvorgänge beschreiben.

In einer weiteren Ausführungsform umfasst das Bereitstellen ein oder mehrerer der erfassten Prozessgrößen als Eingangsgröße für das Modell des maschinellen Lernens und Ausgeben des Qualitätswertes als Ausgangsgröße des Modells des maschinellen Lernens.

In einer weiteren Ausführungsform werden die zur Ermittlung des Qualitätswertes erfassten Prozessgrößen verworfen, wenn der Qualitätswert ein definierbares erstes Qualitätskriterium erfüllt. Da hunderte und teilweise tausende Bauelemente bestückt werden, ist die Menge der Daten, die entsteht, wenn einzelne Bauelemente betrachtet werden beträchtlich. Werden nun die Prozessgrößen verworfen, wenn der Qualitätswert den Anforderungen entspricht so kann Verfahren erheblich effizienter durchgeführt werden und der benötigte Speicherplatz wird verringert. Hierfür kann einen Schwellwert mit entsprechender Toleranz eingeführt werden oder zustandsbasierte Qualitätskriterien Zustände (z.B. "ohne Befund") verwendet werden. In anderen Worten können die Prozessgrößen gelöscht werden, wenn das Bauteil ordnungsgemäß bestückt wurde. Dies führt zu einem erheblich verringerten Speicherbedarf.

In einer weiteren Ausführungsform werden die zur Ermittlung des Qualitätswertes erfassten Prozessgrößen zumindest teilweise gespeichert, wenn der Qualitätswert ein definierbares zweites Qualitätskriterium nicht erfüllt. Indiziert der Qualitätswert, dass das Bauelement nicht ordnungsgemäß bestückt wurde so kann es für Nachverfolgungszwecke und auch für weitere Untersuchungen und/oder Reparaturen sinnvoll sein die Prozessgrößen abzuspeichern.

Generell ist es möglich dem Bauelement eine ID-Nummer mit der Position zuzuweisen, damit später identifiziert werden kann, welches Bauelement ggf. ausgetauscht werden muss.

Die Aufgabe wird weiterhin durch ein Verfahren zum Bestücken mehrerer elektrischer Bauelements auf eine Oberfläche gelöst, umfassend die Schritte:
- Bereitstellen des elektrischen Bauelements,
- Aufnehmen des Bauelements,
- Positionieren des Bauelements und
- Absetzen des Bauelements auf der Oberfläche,
wobei ein Qualitätswert für zumindest eines der Bauelemente mit dem erfindungsgemäßen Verfahren bestimmt wird.

In einer weiteren Ausführungsform wird für mindestens 50% der bestückten Bauelemente jeweils ein Qualitätswert bestimmt. Es ist möglich für alle Bauelemente ein Qualitätswert zu bestimmen, es kann aber sein dass dies nicht nötig ist um die notwendige und geforderte Qualität der bestückten Baugruppen zu erreichen. Es ist möglich nur bei bestimmten, besonders kritischen Bauelementen einen Qualitätswert zu bestimmen. Ergänzend oder alternativ kann mittels einer statistische Verteilung der Bestimmung dafür gesorgt werden, dass im Mittel für jedes der Bauelemente bei einer Anzahl an Baugruppen zumindest eine Anzahl an Qualitätswerten bestimmt werden.

In einer weiteren Ausführungsform wird eine Baugruppe markiert, wenn eine definierbare Anzahl an Qualitätswerten ein oder mehrere definierbare Qualitätskriterien erfüllt oder nicht erfüllt. Die Markierung kann digital in einem der Baugruppe, die die Oberfläche aufweist, zugeordneten Datensatz oder direkt als physikalische Markierung auf der Oberfläche ausgestaltet sein. So können beispielsweise für gut befundene Baugruppen markiert werden und dementsprechend für eine Nachkontrolle oder einen Ausschuss befundene Baugruppen dementsprechend als Ausschuss markiert werden.

Die Aufgabe wird weiterhin durch eine Überwachungseinrichtung für einen Bestückautomat gelöst, wobei die Überwachungseinrichtung zumindest ein Modell aufweist, das zum Ermitteln eines Qualitätswertes nach dem erfindungsgemäßen Verfahren ausgebildet ist. Die Überwachungseinrichtung kann dabei ein Teil einer Steuerung des Bestückautomats sein. Es ist ebenso denkbar, dass eine Industriesteuerung oder ein Teil davon als Überwachungseinrichtung ausgebildet ist. Weiterhin könnte mittels eines sogenannten Edge-Devices eine Überwachungseinrichtung an einem Bestückautomat nachgerüstet werden. Das Modell kann auf jeglichen Rechnern mit einer CPU, einem Arbeitsspeicher und einem nichtflüchtigen Speicher hinterlegt sein und ausgeführt werden.

Die Aufgabe wird weiterhin durch einen Bestückautomat aufweisend eine Überwachungseinrichtung gelöst. Das erfindungsgemäße Verfahren ist so effizient, dass es direkt im Bestückautomat gerechnet werden kann, der dann direkt diese Informationen weiter an die darauffolgende Prozesskette geben kann. Eine Elektronikfertigungslinie kann beispielsweise zumindest einen derartigen Bestückautomat aufweisen und zumindest eine auf den Bestückautomat folgend Transporteinrichtung, die auf Basis des Qualitätswerts den weiteren Fortgang bzw. den Verbleib der die Oberfläche aufweisende Baugruppe im Produktionsprozess entscheiden kann. In anderen Worten kann die Transporteinrichtung auf Basis des Qualitätswerts die Baugruppe aus der Standard Produktionslinie Ausschleusen, wenn der Qualitätswert weitere Inspektionsschritte erforderlich macht. Es kann auch eine erweiterte Inspektion direkt in einer AOI erfolgen.

Im Folgenden wird die Erfindung anhand der in den Figuren dargestellten Ausführungsbeispiele näher beschrieben und erläutert. Es zeigen jeweils schematisch:
- FIG 1: einen fehlerfreien Bestückvorgang eines elektrischen Bauelements,
- FIG 2: ein fehlerhaft aufgenommenes Bauelement,
- FIG 3: zwei fehlerhaft positionierte Bauelemente,
- FIG 4: exemplarische Verläufe von Prozessgrößen,
- FIG 5: einen Bestückautomat aufweisend eine Überwachungseinrichtung
- FIG 6: eine alternative Ausführungsform des Bestückautomaten und
- FIG 7: eine Kombination der Ausführungsformen aus FIG 5 und 6.

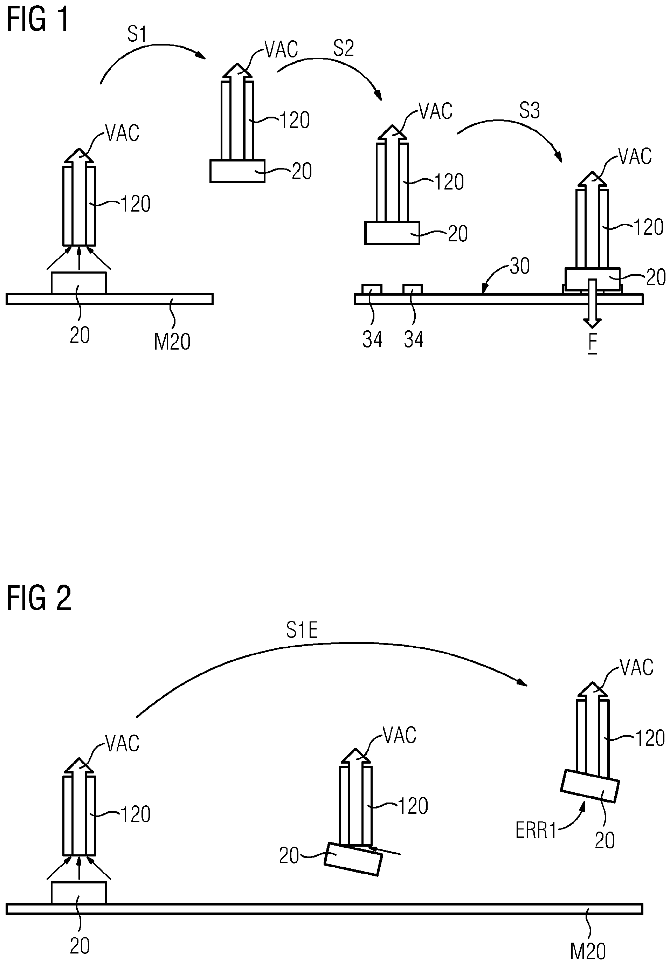

FIG 1 zeigt schematisch einen fehlerfreien Bestückvorgang eines elektrischen Bauelements 20. Das Bauelement 20 wird dabei durch ein Bauelement-Magazin M20 bereitgestellt. Ein Manipulator 120 durchläuft dabei die Schritte, Aufnehmen S1 des Bauelements 20, Positionieren S2 des Bauelements 20 und Absetzen S3 des Bauelements 20 auf eine Oberfläche 30. Die Oberfläche 30 weist dabei Fügematerial 34 auf. Das Bauelement 20 soll dabei so auf dem Fügematerial 34 positioniert werden, dass das Fügematerial 34 in gutem elektrischen und mechanischem Kontakt mit dem Bauelement 20 ist und das Fügematerial 34 gleichzeitig nicht zu sehr herausgepresst wird. Für einen fehlerfreien Bestückvorgang ergibt sich dementsprechend ein Kraftverlauf der durch die Kraftgröße F, die am Manipulator 120 bzw. am elektrischen Bauelement 20 eingezeichnet ist.

Der Manipulator 120 kann dabei als eine Vakuumpipette ausgebildet sein, die mittels eines Unterdrucks, dargestellt durch dessen zugehörige Unterdruckgröße VAC, das Bauelement 20 aufnimmt S1.

FIG 2 zeigt ein fehlerhaftes Aufnehmen S1E eines fehlerhaften Bestückvorgangs. Dabei versucht der Manipulator 120 das Bauelement 20 vom Magazin M20 gerade aufzunehmen. Das Bauelement 20 verkippt aber und der Unterdruck VAC kann nicht ordnungsgemäß aufgebaut werden. Dadurch ist das Bauelement 20 fehlerhaft am Manipulator 120 und kann dementsprechend nicht ordnungsgemäß positioniert werden. Der entstehende Verlauf bzw. die Absolutwerte des Unterdruckgröße VAC ist/sind dementsprechend im Vergleich zu einem fehlerfreien Aufnehmen S1 verändert.

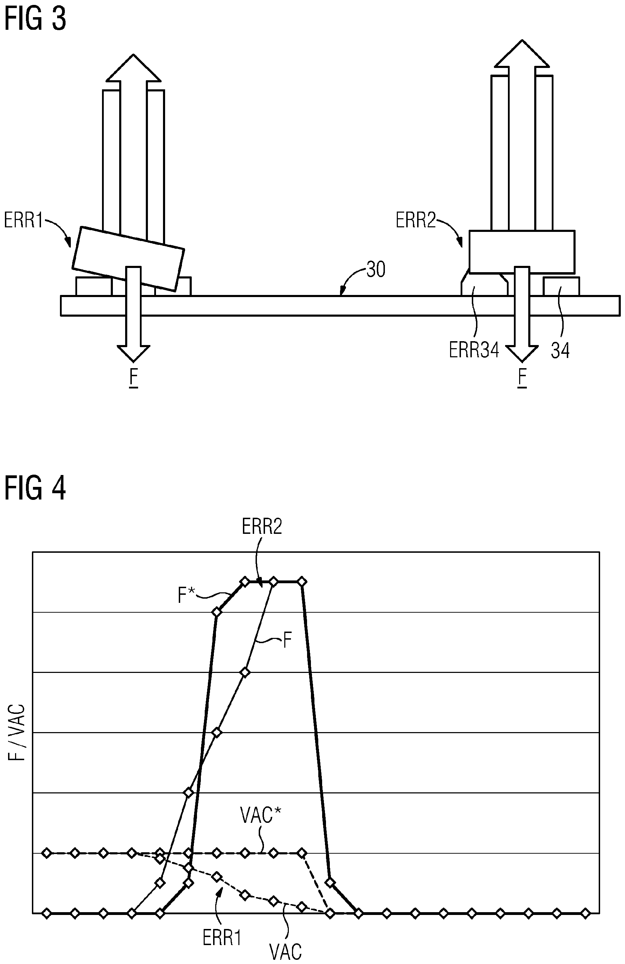

FIG 3 zeigt zwei fehlerhaft positionierte Bauelemente 20. Das linke Bauelement 20, das den ersten Fehler ERR1 aufweist, wurde wie in FIG2 gezeigt schräg bzw. gekippt aufgenommen und dementsprechend schräg bzw. gekippt auf das Fügematerial 34 aufgesetzt.

Das rechte Bauelement 20, das den zweiten Fehler ERR2 aufweist wurde ordnungsgemäß vom Manipulator 120 aufgenommen, aber einer der beiden Fügematerial-Depots ist fehlerhaft. In diesem Fall wurde das rechte Fügematerial 34 ordnungsgemäß aufgebracht, wobei das fehlerhafte Fügematerial ERR34 auf der linken Seite zu groß ist, bspw. weil zu viel Fügematerial dispenst wurde.

In beiden Fällen ist eine Abweichung in der Kraftgröße F zu erwarten.

FIG 4 zeigt exemplarisch Verläufe von Prozessgrößen, hier eine Kraftgröße F und eine Unterdruckgröße VAC mit ihren dazugehörigen Erfahrungswerten F* und VAC*, wobei die Erfahrungswerte einen vollständigen und korrekten Bestückvorgang eines elektrischen Bauelements 20 beschreiben.

Die Erfahrungswerte können dabei allgemein oder für Arten / Größen von Bauelementen 20 zur Verfügung gestellt sein. Es ist denkbar, dass Gruppen von Bauelementen 20 als Erfahrungswerte F*, VAC* zur Verfügung gestellt werden. Es ist weiterhin denkbar, dass zur Initialisierung des Modells 40 eine bestimmte Anzahl an Bauelementen 20 bestückt wird um fehlerfreie und für eine spezifische Anlage gültige Erfahrungswerte F*, VAC* zur Verfügung zu stellen. Die vorliegenden Verläufe sind zeitdiskret abgetastet, könnten aber ebenso zu festen Zustandspunkten abgetastet sein.

Im vorliegenden Fall weisen die Prozessgrößen F, VAC einen ungewöhnlichen Verlauf auf. Hier kann durch einen Vergleich der Verläufe der Prozessgrößen F, VAC mit den Erfahrungswerten F*, VAC* darauf geschlossen werden, dass der Bestückvorgang nicht optimal war und ein Fehler ERR1, ERR2 vorliegt.

Es liegt ein erster Fehler ERR1 vor, der sich in einer Abweichung der Unterdruckgröße VAC ausdrückt, sowie ein zweiter Fehler ERR2, der sich in einer Abweichung der Kraftgröße F ausdrückt. Die Fehler, wie sie in FIG 2 und 3 verursacht wurden sind somit in den Prozessgrößen F, VAC erkennbar, wie sie in FIG 4 gezeigt werden. Es ist möglich einzelne Abtastpunkte zu wählen, zu denen ein Fehler erkennbar ist oder Verläufe zu analysieren.

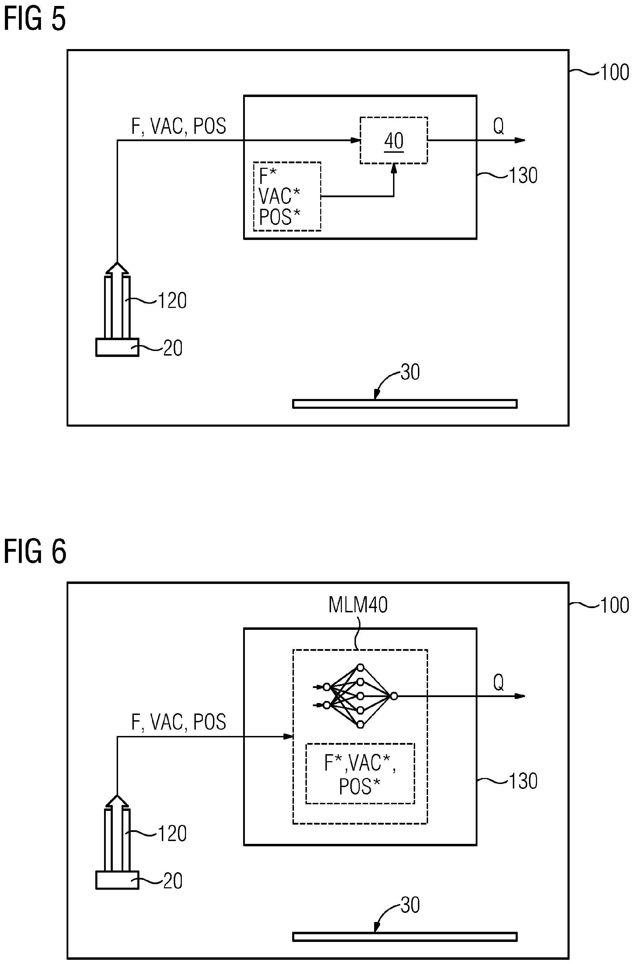

FIG 5 zeigt schematisch einen Bestückautomat 100 aufweisend eine Überwachungseinrichtung 130. Weiterhin schematisch gezeigt ist ein Manipulator 120 der aktuell ein elektrisches Bauelement 20 auf eine Oberfläche 30 positionieren soll. Bei diesem Positionierungsvorgang fallen Prozessgrößen F, VAC, POS an. Diese Prozessgrößen F, VAC, POS werden der Überwachungseinrichtung 130 zur Verfügung gestellt. Die Überwachungseinrichtung 130 ermittelt mittels eines Modells 40 auf Basis von Erfahrungswerten F*, VAC*, POS* für die Prozessgrößen F, VAC, POS einen Qualitätswert Q. Die Erfahrungswerte F*, VAC*, POS* sind hier schematisch als Teil der Überwachungseinrichtung dargestellt, was beispielsweise als in einem internen Speicher als Lookup Table der Fall sein kann.

FIG 6 zeigt schematisch einen Bestückautomat 100 aufweisend eine Überwachungseinrichtung 130, ähnlich wie in FIG 5. Das Modell ist hier als ein trainiertes Modell des maschinellen Lernens MLM40, z.B. als ein trainiertes neuronales Netzwerk, ausgebildet. Dabei wurden die Erfahrungswerte F*, VAC*, POS* zum Training des Modells des maschinellen Lernens MLM40 bereits Teil des Modells MLM40. Je nach Anzahl der verwendeten Parameter erhält das Modells MLM40 ein oder mehrere der Prozessgrößen F, VAC, POS als Eingangsgröße und ermittelt daraus einen Qualitätswert Q, der angibt, ob die Bestückung des aktuellen Bauelements 20 erfolgreich war, oder nicht. Da die Prozessparameter und die Erfahrungswerte als Daten vorliegen und auch einfach hinsichtlich der Qualität der Bestückung gelabelt werden können, so bieten sich vor allem Verfahren zum überwachten maschinellen Lernen an.

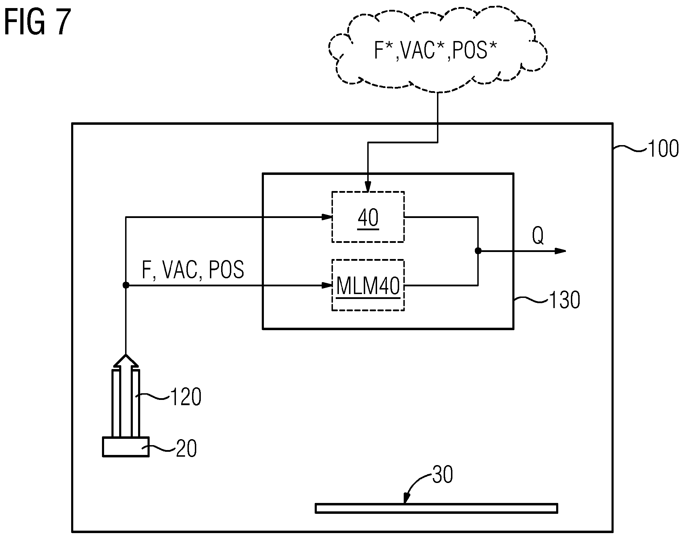

FIG 7 zeigt eine Kombination der Ausführungsformen aus FIG 5 und 6. Dazu ist ein Modell 40, dass auf einem Vergleich der Erfahrungswerte F*, VAC*, POS* mit den Prozessgrößen F, VAC, POS basiert mit einem trainierten Modell des maschinellen Lernens MLM40 kombiniert. So können einfachere Fehler durch direkten Vergleich im Modell 40 ermittelt werden und außergewöhnliche Fehler durch das trainierte Modell des maschinellen Lernens MLM40. Es ist denkbar hier einen Mittelwert der Ausgangsgrößen der beiden Modelle 40, MLM40 als Qualitätswert Q zu ermitteln. Alternativ oder ergänzend kann einem der beiden Modelle 40, MLM40 eine höhere Gewichtung zugewiesen werden. Dies hat den Vorteil, dass bestimmte Fehler auf jeden Fall erkannt werden können.

Weiterhin sind in FIG 7 die Erfahrungswerte F*, VAC*, POS* in einer außerhalb des Bestückautomats 100 liegenden Speichervorrichtung - z.B. Cloudbasiert - gespeichert. Es ist denkbar, dass eine Datenbank für eine Vielzahl an möglichen Kombinationen von Manipulatoren 120 und Bauelementen 20 Erfahrungswerte F*, VAC*, POS* aufweist und diese an mehrere Bestückautomaten 100 bereitstellt.

Zusammenfassend betrifft die Erfindung ein Verfahren zum Ermitteln eines Qualitätswertes Q beim Bestücken eines elektrischen Bauelements 20 auf eine Oberfläche 30. Um Prozessabweichungen in der Elektronikfertigung frühzeitig zu erkennen und den Fertigungsprozess zu verbessern werden die folgenden Schritte vorgeschlagen:
- Erfassen ein oder mehrerer Prozessgrößen F, VAC, POS beim Bestücken des Bauelements 20,
- Ermitteln des Qualitätswertes Q durch ein Modell 40, das auf Basis von Erfahrungswerten F*, VAC*, POS* für die Prozessgrößen P, VAC, POS den Qualitätswert Q ausgibt.
Die Erfindung betrifft weiterhin ein Verfahren zum Bestücken von Bauelementen 20, eine Überwachungseinrichtung 130 und einen Bestückautomat 100.

### Bezugszeichen

- 100: Bestückautomat
- 120: Manipulator
- 130: Überwachungseinrichtung
- M20: Magazin für Bauelemente
- 20: elektrisches Bauelement
- 30: Oberfläche
- 34: Fügematerial
- Q: Qualitätswert
- Q1, Q2: Qualitätskriterien
- F: Kraftgröße
- VAC: Unterdruckgröße
- POS: Position
- F*, VAC*, POS*: Erfahrungswerte
- ERR1, ERR2: Fehler

- 40: Modell
- MLM40: Modell des maschinellen Lernens

## Patentansprüche

1. Verfahren zum Ermitteln eines Qualitätswertes (Q) beim Bestücken eines elektrischen Bauelements (20) auf eine Oberfläche (30), umfassend die Schritte:
- Erfassen ein oder mehrerer Prozessgrößen (F, VAC, POS) beim Bestücken des Bauelements (20),
- Ermitteln des Qualitätswertes (Q) durch ein Modell (40), das auf Basis von Erfahrungswerten (F*, VAC*, POS*) für die Prozessgrößen (P, VAC, POS) den Qualitätswert (Q) ausgibt.

2. Verfahren nach Anspruch 1, wobei beim Erfassen zumindest eine Prozessgröße (F, VAC, POS) für die folgenden Schritte, insbesondere für jeden der Schritte, erfasst wird:
- Aufnehmen (S1) des Bauelements (20),
- Positionieren (S2) des Bauelements (20) und/oder
- Absetzen (S3) des Bauelements (20) auf der Oberfläche (30).

3. Verfahren nach Anspruch 1 oder 2, wobei das Modell (40) zum Bestimmen des Qualitätswertes (Q) auf Basis einer Abweichung von den Erfahrungswerten (F*, VAC*, POS*) ausgebildet ist.

4. Verfahren nach einem der vorhergehenden Ansprüche, wobei als Prozessgröße (F, VAC, POS) zumindest eine Unterdruckgröße (VAC) und/oder ein Kraftgröße (F) für das Bauelement (20) erfasst wird.

5. Verfahren nach einem der vorhergehenden Ansprüche, wobei als Prozessgröße (F, VAC, POS) zumindest eine Position (POS), eine Geschwindigkeit und/oder eine Beschleunigung des Manipulators (120) und/oder des Bauelements (20) erfasst wird.

6. Verfahren nach einem der vorhergehenden Ansprüche, wobei die Prozessgrößen (F, VAC, POS) als Zeitverlauf eines Bestückvorgangs des Bauelements (20) erfasst werden.

7. Verfahren nach einem der vorhergehenden Ansprüche, wobei das Modell (40) ein mit den Erfahrungswerten (F*, VAC*, POS*) trainiertes Modell des maschinellen Lernens (MLM40) umfasst.

8. Verfahren nach Anspruch 7, umfassend Bereitstellen ein oder mehrerer der erfassten Prozessgrößen (F, VAC, POS) als Eingangsgröße (IN) für das Modell des maschinellen Lernens (MLM40) und Ausgeben des Qualitätswertes (Q) als Ausgangsgröße (OUT) des Modells des maschinellen Lernens (MLM40).

9. Verfahren nach einem der vorhergehenden Ansprüche, wobei die zur Ermittlung des Qualitätswertes (Q) erfassten Prozessgrößen (F, VAC, POS) verworfen werden, wenn der Qualitätswert (Q) ein definierbares erstes Qualitätskriterium (Q1) erfüllt.

10. Verfahren nach einem der vorhergehenden Ansprüche, wobei die zur Ermittlung des Qualitätswertes (Q) erfassten Prozessgrößen (F, VAC, POS) zumindest teilweise gespeichert werden, wenn der Qualitätswert (Q) ein definierbares zweites Qualitätskriterium (Q2) nicht erfüllt.

11. Verfahren zum Bestücken mehrerer elektrischer Bauelements (20) auf eine Oberfläche (30), umfassend die Schritte:
- Bereitstellen des elektrischen Bauelements (20),
- Aufnehmen (S1) des Bauelements (20),
- Positionieren (S2) des Bauelements (20) und
- Absetzen (S3) des Bauelements (20) auf der Oberfläche (30), wobei ein Qualitätswert (Q) für zumindest eines der Bauelemente (20) mit einem Verfahren nach einem der vorhergehenden Schritte bestimmt wird.

12. Verfahren nach Anspruch 11, wobei für mindestens 50% der bestückten Bauelemente (20) jeweils ein Qualitätswert (Q) bestimmt wird.

13. Verfahren nach Anspruch 11 oder 12, umfassend ein Markieren einer Baugruppe (200), wenn eine definierbare Anzahl an Qualitätswerten (Q) ein oder mehrere definierbare Qualitätskriterien (Q1, Q2) erfüllt oder nicht erfüllt.

14. Überwachungseinrichtung (130) für einen Bestückautomat, aufweisend zumindest ein Modell (40) das zum Ermitteln eines Qualitätswertes (Q) nach einem Verfahren nach einem der Ansprüche 1 - 20 ausgebildet ist.

15. Bestückautomat (100) aufweisend eine Überwachungseinrichtung (130) nach Anspruch 14.
